(19) Europäisches Patentamt
European Patent Office
Office européen des brevets

(11) **EP 3 138 218 B1**

(12) **EUROPEAN PATENT SPECIFICATION**

(45) Date of publication and mention
of the grant of the patent:
**07.10.2020  Bulletin 2020/41**

(51) Int Cl.:
***H03K 5/1252*** *(2006.01)*    ***H03K 5/24*** *(2006.01)*

(21) Application number: **14890582.1**

(86) International application number:
**PCT/CN2014/076596**

(22) Date of filing: **30.04.2014**

(87) International publication number:
**WO 2015/165074 (05.11.2015 Gazette 2015/44)**

(54) **APPARATUS AND METHOD FOR FILTERING NOISES IN SIGNAL**

VORRICHTUNG UND VERFAHREN ZUM FILTERN VON GERÄUSCHEN BEI EINEM SIGNAL

APPAREIL ET PROCÉDÉ DE FILTRAGE DE BRUITS DANS UN SIGNAL

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**08.03.2017  Bulletin 2017/10**

(73) Proprietor: **ABB Schweiz AG**
**5400 Baden (CH)**

(72) Inventors:
• **LIU, Wei**
  **Hangzhou**
  **Zhejiang 310015 (CN)**
• **HE, Liang**
  **Hangzhou**
  **Zhejiang 310012 (CN)**
• **LOHBECK, Axel**
  **Hangzhou**
  **Zhejiang 311215 (CN)**

(74) Representative: **Zimmermann & Partner**
**Patentanwälte mbB**
**Josephspitalstr. 15**
**80331 München (DE)**

(56) References cited:
**EP-A1- 0 664 612      CN-A- 101 515 796
CN-A- 102 832 917      CN-A- 103 684 621
GB-A- 2 028 064        US-A- 4 204 170
US-A1- 2014 055 172**

## Description

## Field of Invention

Embodiments of the present disclosure relate to an apparatus and a method for filtering noises in a signal, particular for filtering both positive impulse noises and negative impulse noises in a pulse signal.

## Background of Invention

Pulse input frequency measurement modules are widely used in the process automation industry where pulse sequences with a vast variety of frequencies have to be dealt with. Due to the complex electrical environment during usage, there will be interference between signals, which may lead to abnormal behaviors of signal processing, and these abnormal behaviors are typically called noises.

For an input with certain frequency, noises may cause inaccurate values of processed signal and lead to incorrect calculation. Because frequency is usually measured by calculating the time interval between high level and low level, presence of noises may result in a big signal change, which is unwanted for especially a critical process.

It is desirable for filtering a pulse signal with a hardware solution which would filter both positive impulse noises and negative impulse noises.

Resistor - capacitor filters (RC filter) are commonly used for filtering noises. However, a simple RC filter may only filter certain kind of noise due to the complex signal status, and therefore cannot meet the requirements as desired.

Field Programmable Gate Array (FPGA) may be used for filtering noises which is capable of calculating the correct frequency and filtering unwanted noises. However, a FPGA is relatively expensive and requires certain efforts for development.

GB 2 028 064 A relates to a narrow band transmission system with level divider for an audio input signal, RC filter networks for eliminating the switching noise in the input signal and respective amplifiers for delivering a high frequency component signal and a low frequency component signal.

## Summary of Invention

In view of above, one of the objectives of the present disclosure is to provide an apparatus and a method for filtering different noises in a signal, preferably in a pulse signal by using hardware with a more cost effective solution.

According to one aspect of the present disclosure, there is provided an apparatus for filtering noises in input signal, according to independent claim 1.

According to one embodiment of the present disclosure, the hysteresis filter circuit may be a Schmitt trigger.

According to one embodiment of the present disclosure, the first RC filter may comprise a first resistor and a first capacitor, and wherein the first RC filter is constructed in the form of a low pass filter.

According to one embodiment of the present disclosure, the second RC filter may comprise a second resistor and a second capacitor, and wherein the second RC filter is constructed in the form of a high pass filter.

According to one embodiment of the present disclosure, the first comparator may comprise a first operational amplifier, and the second comparator may comprise a second operational amplifier.

According to one embodiment of the present disclosure, a cathode of a first diode may be connected to the output of the first comparator to receive the second signal, so that the first diode enables falling edges of the second signal to change the output of the combiner circuit to low level, while rising edges of the second signal not to change the output of the combiner circuit.

According to one embodiment of the present disclosure, the anode of a second diode may be connected to the output of the second comparator to receive the third signal, so that the second diode enables rising edges of the third signal to change the output of the combiner circuit to high level, while falling edges of the third signal not to change the output of the combiner circuit.

According to one embodiment of the present disclosure, input voltage of the first RC filter is higher than the reference voltage of the first comparator and input voltage of the second RC filter is higher than the reference voltage of the second comparator.

According to one embodiment of the present disclosure, the combiner circuit may comprise a third operational amplifier, a third resistor and a third capacitor, the third operational amplifier may comprise a non-inverting input, an inverting input and an output, wherein the third resistor and the third capacitor are electrically coupled in parallel with one end connected to the non-inverting input of the third operational amplifier and the other end connected to the output of the third operational amplifier.

According to another aspect of the present disclosure, there is provided a method for filtering noises in an input signal, according to independent claim 9.

According to one embodiment of the present disclosure, the first RC filter may comprise a first resistor and a first capacitor constructed in the form of a low pass filter, and the second RC filter may comprise a second resistor and a second capacitor constructed in the form of a high pass filter.

According to one embodiment of the present disclosure, the combiner circuit may comprise an operational amplifier.

According to one embodiment of the present disclosure, the combiner circuit may comprise a third operational amplifier, and a third resistor and a third capacitor, the third operational amplifier may comprise a non-inverting input, an inverting input and a output, wherein the third resistor and the third capacitor are electrically coupled in parallel with one end connected to the non-inverting input of the third operational amplifier and the other end connected to the output of the third operational amplifier.

The present disclosure brings advantages in general that it utilizes common electronic components available on the market such as operational amplifiers for acting as comparators. This brings about a major advantage of the present disclosure that the solution only involves basic components which are cheap and easily available such as resistors, capacitors, operational amplifiers, transistors (e.g., MOSFET), instead of involving components such as FPGA which is relatively costly. Also, the present disclosure may be used for filtering different types of noises such as hysteresis noises, positive impulse noises as well as negative impulse noises.

## Brief Description of Drawings

Embodiments of the invention will now be described, by way of example only, with reference to the accompanying drawings, in which:

Figure 1 illustrates a schematic diagram of an apparatus for filtering noises in a signal according to one embodiment of the present disclosure;

Figure 2 illustrates another schematic diagram of an apparatus for filtering noises in a signal according to one embodiment of the present disclosure;

Figure 3 illustrates a circuit diagram of an apparatus for filtering noises in a signal according to one embodiment of the present disclosure; and

Figure 4 schematically illustrates waveforms of signals at different states as a function of time according to one embodiment of the present disclosure.

## Detailed Description of Embodiments

Reference will now be made in detail to several embodiments of the present disclosure, example of which are illustrated in the accompanying figures. It is noted that wherever practicable similar or like reference numbers may be used in the figures, and may indicate similar or like functionality. The figures depict embodiments of the present disclosure for purposes of illustration only. One skilled in the art will readily recognize from the following description that alternative embodiments of the structures and methods illustrated herein may be employed without departing from the principles of the present disclosure described therein.

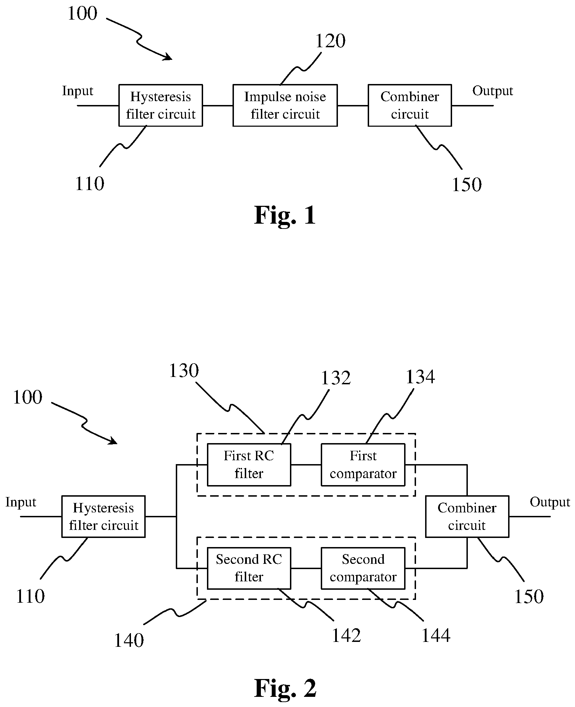

Fig. 1 illustrates a schematic diagram of an apparatus 100 for filtering noises in a signal according to one embodiment of the present disclosure.

In accordance with this embodiment, as shown in Fig. 1, the apparatus 100 includes a hysteresis filter circuit 110 for filtering hysteresis noises, an impulse noise filter circuit 120 for filtering both positive impulse noises and negative impulse noises and generating two filtered signals, and a combiner circuit 150 for combining the two filtered signals to provide an output signal.

According to an embodiment of the present disclosure, the hysteresis filter circuit 110 has a first terminal for receiving an input signal, typically as the form of pulse sequences. The input signal that the present disclosure aims to process normally contains noise types such as hysteresis noises, positive impulse noises and negative impulse noises. The hysteresis filter circuit 110 is used for eliminating the hysteresis noises from the input signal and generating a digital signal, where the generated digital signal after the processing of hysteresis filter circuit 110 switches between high level and low level. The hysteresis filter circuit 110 can be realized by a known Schmitt trigger, which will not further described in details.

According to the embodiment of this present disclosure, the impulse noise filter circuit 120 receives the signal from the output of the hysteresis filter circuit 110. In particular, a second terminal of the hysteresis filter circuit 110 is electrically connected to a first terminal of an impulse noise filter circuit 120. By such connection, the signal from the hysteresis filter circuit 110 is received by the impulse noise filter circuit 120 at its first terminal. According to one example, the impulse noise filter circuit 120 receives the signal from the output of the hysteresis filter circuit 110, and processes the signal to remove both positive and negative impulse noises respectively and typically generate two signals, namely, one with negative impulse noises removed and the other with positive noises removed.

According to the embodiment of this present disclosure, the combiner circuit 150 receives the signals from the impulse filter circuit 120. A second terminal of the impulse noise filter circuit 120 is electrically connected to a first terminal of a combiner circuit 150. The combiner circuit 150 is used for combining the two signals outputted from the impulse noise filter circuit 120. Finally a signal with hysteresis noises, negative and positive noises removed will be outputted from a second terminal of the combiner circuit 150.

More detailed descriptions on how the impulse noise filter circuit 120 removes negative impulse noises and positive impulse noises separately will be described with reference to Fig. 2 as below.

In one embodiment of the present disclosure, as shown in Fig. 2, the impulse noise filter circuit 120 further includes a negative noise filter circuit 130 and a positive noise filter circuit 140, which are connected in parallel. Both the negative noise filter circuit 130 and the positive noise filter circuit 140 receive the signal from the hysteresis filter circuit 110 and output two signals to a same input of the combiner circuit 150.

The negative noise filter circuit 130 contains two modules, namely, a first RC filter 132 and a first comparator 134, while the positive noise filter circuit 140 also contains two modules, namely, a second RC filter 142 and a second comparator 144.

The first RC filter 132 is connected to the first comparator 134 in series, and a first terminal of the first RC filter 132 is connected to the second terminal of the hysteresis filter circuit 110, a second terminal of the first RC filter 132 is connected to the first terminal of the first comparator 134, and a second terminal of the first comparator 134 is connected to the first terminal of the combiner circuit 150.

Similarly, the second RC filter 142 is connected to the second comparator 144 in series, and a first terminal of the second RC filter 142 is connected to the second terminal of the hysteresis filter circuit 110, a second terminal of the second RC filter 142 is connected to the first terminal of the second comparator 144, and a second terminal of the second comparator 144 is connected to the first terminal of the combiner circuit 150.

In other words, as shown in Fig. 2, the first RC filter 132 and the first comparator 134 constitute a negative noise filter circuit 130 as enclosed by a dashed box, while the second RC filter 142 and the second comparator 144 constitute a positive noise filter circuit 140 as enclosed by the other dashed box.

By the configuration as illustrated in Fig. 2 and described above, the signal with hysteresis noises filtered after the hysteresis filter circuit 110 is separated into two signals which will be respectively processed by the negative noise filter circuit 130 and the positive noise filter circuit 140. The first RC filter 132 and the second RC filter 142 are used for removing unwanted negative and positive impulse noises occurred in respective pulse sequences, respectively. The first comparator 134 and the second comparator 144 are used for generating respective filtered signals.

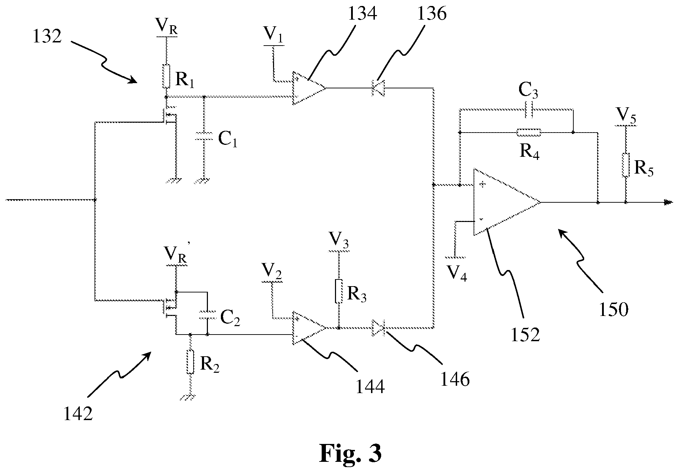

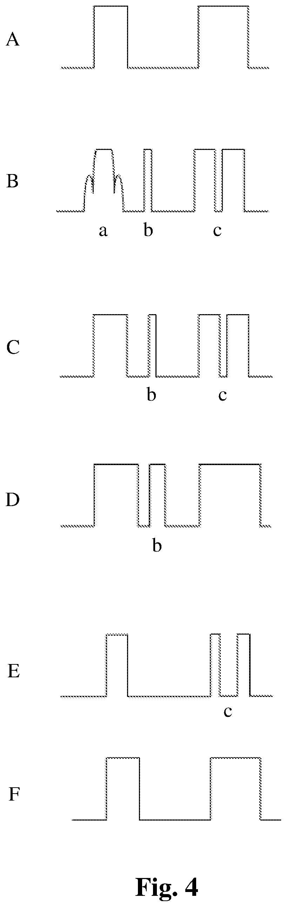

Fig. 3 illustrates a circuit diagram of an apparatus for filtering noises in a signal according to one embodiment of the present disclosure; and Fig. 4 schematically illustrates waveforms of signals at different states as a function of time according to one embodiment of the present disclosure. Fig. 3 will be explained below in conjunction with the description of Fig. 4.

Fig. 3 shows the circuit diagram with modules including the negative noise filter circuit 130, the positive noise filter circuit 140 and the combiner circuit 150 as well as their components.

Waveform A of Fig. 4 illustrates a correct signal without contamination, i.e., a noise-free ideal signal. Meanwhile, waveform B of Fig. 4 illustrates an actual signal (i.e., an input signal) with hysteresis noise, negative impulse noise and positive impulse noise. The hysteresis noise is indicated by "a" where such noisy signal typically has contaminated rising and falling edges, which need to be converted into a signal having only high and low levels instead of a continuous curve with multiple levels in vicinity of the edges. The positive impulse noise is indicated by "b" where a high-level impulse signal occurs at the place in which the correct signal ought to be low. Accordingly, the negative impulse noise is indicated by "c" where a low-level impulse signal occurs at the place in which the correct signal ought to be high.

After being processed by the hysteresis filter circuit 110, the processed signal can be seen in waveform C of Fig. 4 without hysteresis noises. However, the positive impulse noise "b" and the negative impulse noise "c" need to be further eliminated from the signal.

The signal without hysteresis noises is also called a first signal in the context. As shown in Fig. 3, the first signal is separated into two identical signals and provided to the first RC filter 132 and the second RC filter 142, respectively. Each of the separated first signal controls a transistor, preferably a MOSFET.

In one embodiment of the present disclosure, as shown in Figure 3, the second terminal of the hysteresis filter circuit 110 is connected to the first terminal of the first RC filter 132 as discussed above, where the first terminal of the first RC filter 132 corresponds to a first terminal of a first transistor. A second terminal of the first transistor is connected to ground, and a third terminal of the first transistor is connected to a second terminal of a resistor $R_1$. By actuating the first terminal of the first transistor, the first transistor is open and the second terminal of the resistor $R_1$ is electrically connected with the ground. A first terminal of the resistor $R_1$ is supplied with a voltage $V_R$, which is hereinafter referred to as input voltage of RC filter The second terminal of the resistor $R_1$ is further connected to a first terminal of a capacitor $C_1$ as well as the inverting input of the first comparator 134. A second terminal of the capacitor $C_1$ is connected to the ground. The voltage $V_R$, the resistor $R_1$, the capacitor $C_1$ and the inverting input of the first comparator 134 are constructed in the form of an RC low pass filter in this embodiment. The non-inverting input of the first comparator 134 is supplied with a voltage $V_1$ in this embodiment, which is hereafter referred to as "reference voltage" of the first comparator.

In one embodiment of the present disclosure, as shown in Figure 3, the second terminal of the hysteresis filter circuit 110 is connected to the first terminal of the second RC filter 142 as discussed above, where the first terminal of the second RC filter 142 corresponds to a first terminal of a second transistor. A second terminal of the second transistor is connected to a first terminal of a resistor $R_2$, and a third terminal of the second transistor is supplied with a voltage $V_R'$, which preferably shares the same value as the voltage $V_R$ as described above. By actuating the first terminal of the second transistor, the second transistor is open and the first terminal of the resistor $R_2$ is supplied with the voltage $V_R'$. A second terminal of the resistor $R_2$ is connected to the ground. A first terminal of a capacitor $C_2$ is connected to the third terminal of the second transistor, i.e., the first terminal of the capacitor $C_2$ is supplied with the voltage $V_R'$. The first terminal of the resistor $R_2$ is connected to a second ter-

minal of the capacitor $C_2$ as well as the inverting input of the second comparator 144. The voltage $V_R'$, the resistor $R_2$, the capacitor $C_2$ and the inverting input of the second comparator 144 are constructed in the form of an RC high pass filter in this embodiment. The non-inverting input of the second comparator 144 is supplied with a voltage $V_2$ in this embodiment.

According to the embodiments of the present disclosure, when the first transistor is switched on, the capacitor $C_1$ will be short circuited, and when the first transistor is switched off, the voltage $V_R$ will charge the capacitor $C_1$. Furthermore, when the second transistor is switched on, the capacitor $C_2$ will be short circuited, and when the second transistor is switched off, the voltage $V_R'$ will charge the capacitor $C_2$.

According to the embodiments of the present disclosure, when the first transistor is switched off, the resistor $R_1$ and the capacitor $C_1$ constitute a RC filter in the form of a low pass filter with an input voltage $V_R$, while when the second transistor is switched off, the capacitor $C_2$ and the resistor $R_2$ constitute a RC filter in the form of a high pass filter with an input voltage $V_R'$. The respective RC filters 132 and 142 are connected to the inverting inputs of the first comparator 134 and the second comparator 144, respectively.

According to the embodiments of the present disclosure, when the value of the first signal is changed from low to high level, the first transistor is switched on and thus the capacitor $C_1$ is short circuited. As a result, the inverting input of the first comparator 134 is grounded, and the signal outputted to the first comparator 134 is a zero signal, which results in a high level output from the first comparator 134. On the other hand, when the value of the first signal is changed from high to low level, the first transistor is switched off, and the voltage $V_R$ charges the capacitor $C_1$ and therefore the first RC filter 132 outputs to the first comparator 134 a non-zero voltage which is hereinafter referred to as output voltage of RC filter. Thus, the signal outputted to the inverting input of the first comparator 134 is reversed compared with the first signal (which will be flipped back after the first comparator 134) and delayed due to the property of a low pass filter. Therefore, the first comparator 134 will output a second signal as shown by waveform D of Fig. 4 with the negative impulse noise "c" removed. As shown, the falling edges of the second signal are delayed compared with the first signal, while the rising edges of the second signal is substantially consistent with the first signal.

According to the embodiments of the present disclosure, when the value of the first signal is changed from high to low level, the second transistor is switched off, and the second RC filter 142 outputs a non-zero signal to the second comparator 144 right away because of the property of an RC high pass filter circuit. Therefore, the signal outputted to the inverting input of the second comparator 144 is reversed compared with the first signal (which will be flipped back after the second comparator 144). On the other hand, when the value of the first signal is changed from low to high level, the second transistor is switched on and thus the capacitor $C_2$ is short circuited. Because of the existence of the charged capacitor $C_2$, the voltage drop of the signal outputted to the inverting input of the second comparator 144 is delayed. Therefore, the second comparator 144 will output a third signal as shown by waveform E of Fig. 4 with the positive impulse noise "b" removed. As shown, the rising edges of the third signal are delayed compared with the first signal, while the falling edges of the third signal is substantially consistent with the first signal.

It should be noted that, in alternative embodiments, transistors and filters may be configured in other forms, or types of the transistors and of the filters may be different from above embodiment as illustrated, once they can achieve the same technical effects with the present disclosure. For example, filters can be constructed in other form, such as those filters consisting of an inductor and a resistor. However, the configuration with one filter acting as a low pass filter and the other filter acting as a high pass filter is preferred. Utilizing a resistor and a capacitor for constructing a filter is cost effective. Also, different impulse noises can be selectively filtered by adjusting the values of the resistor and the capacitor with in addition to different delayed period of time.

Referring to Fig. 3, the voltage $V_1$ is connected to the non-inverting input of the first comparator 134, and input voltage of first RC filter $V_R$ should be larger than $V_1$ for allowing the first comparator 134 functioning. Similarly, the voltage $V_2$ is connected to the non-inverting input of the second comparator 144, and $V_R'$ should be larger than $V_2$ for allowing the second comparator 144 functioning. It should be understood by persons skilled in the art that though input voltage of RC filter is discussed here, purpose of this setting is to make sure output voltage of RC filter when its capacitor being not short-circuited is larger than the reference voltage of the comparator, and input voltage and output voltage of RC filter will not be differentiated further in this disclosure since in theory output voltage of the RC filter is infinitely approximate input voltage of the RC filter.

According to one embodiment of the present disclosure, the second comparator 144 is followed by a second diode 146 and the first comparator 134 is followed by a reversely connected first diode 136.

According to one embodiment of the present disclosure, the combiner circuit 150 includes a third comparator 152, a resistor $R_4$, a capacitor $C_3$ and a pull-up resistor $R_5$. The signals after the first diode 136 and the second diode 146 are both connected to the first terminal of the combiner circuit 150, more specifically, to the non-inverting input of the third comparator 152 of the combiner circuit 150 for forming a combined signal. By this configuration, the second diode 146 allows the third comparator 152 being flipped when the third signal changes from low to high, while the first diode 136 allows the third comparator 152 being flipped when the second signal changes from high to low. In other words, if the third signal is low, the combined signal will be larger than a voltage $V_4$ connected to the inverting input of the third comparator 152 despite of the state of the second signal. This behavior eliminates the positive impulse noises. Rising edges of the third signal will pull the output signal of the combiner circuit 150 to high. When the output signal is high, falling edges of the second signal will lower the output signal to low despite of the state of the third signal. This behavior eliminates the negative impulse noises.

As discussed above, in this embodiment, because the rising edges of the third signal will flip the third comparator 152, the stability of the third signal is vital. Therefore, a pull-up resistor $R_3$ and a voltage $V_3$ are provided for stabilizing the high level state of the third signal. For similar reason, the pull-up resistor $R_5$ and a voltage $V_5$ are provided for outputting the output signal out of the combiner circuit 150.

According to this embodiment, the capacitor $C_3$ and the resistor $R_4$ are coupled to the third comparator 152 across the non-inverting input and the output, where the capacitor $C_3$ and the resistor $R_4$ are in parallel. By this configuration, the capacitor C3 is used to eliminate the impact of some parasitic parameters, and the combiner circuit 150 is constructed for combining the signals after both diodes 136 and 146.

According to this embodiment, as seen from waveform F of Fig. 4, the output signal shares a substantial identical waveform compared with the correct signal or waveform A, except that the output signal exhibits certain delay in time which is induced by those filters presented in the apparatus.

With the circuit constructed as shown in Fig. 3, the time duration of an impulse noise that may be filtered can be determined by the following equations:

$$t_1 = -R_1 C_1 \ln\left(1 - \frac{V_1}{V_R}\right)$$

$$t_2 = -R_2 C_2 \ln\left(\frac{V_2}{V_R}\right)$$

where $t_1$ is the longest time duration of a negative impulse noise that may be filtered by the first RC filter 132, and $t_2$ is the longest time duration of a positive impulse noise that may be filtered by the second RC filter 142. Preferably, $t_1$ should be equal to $t_2$. In addition, the value of $V_4$ can be determined by the followings:

$V_4 > 0.7V$

$$V_4 < 0.7V + (V_3 - 0.7V)\frac{R_4}{R_4 + R_3}$$

If margin is considered:

$$V_4 = \frac{0.7V + (V_3 - 0.7V)\dfrac{R_4}{R_4 + R_3}}{2}$$

The embodiment may utilize common electronic components available on the market such as operational amplifiers for acting as the first comparator 134, the second comparator 144 and the third comparator 152. This brings about a major advantage of the present disclosure that the solution only involves basic components which are cheap and easily available such as resistors, capacitors, operational amplifiers, transistors (e.g., MOSFET), instead of involving components such as FPGA which is relatively costly. Also, the present disclosure may be used for filtering different types of noises such as hysteresis noises, positive impulse noises as well as negative impulse noises.

**Claims**

1. An apparatus (100) for filtering noises in an input signal (B), comprising:

   a hysteresis filter circuit (110) configured to filter hysteresis noises in the input signal (B) to obtain a first signal (C);
   an impulse noise filter circuit (120) comprising

   a negative noise filter circuit (130) configured to filter negative impulse noises in the first signal (C) to obtain a second signal (D); and
   a positive noise filter circuit (140) coupled with the negative noise filter circuit (130) in parallel, and configured to filter positive impulse noises in the first signal (C) to obtain a third signal (E); and

   a combiner circuit (150) configured to combine the second signal (D) and the third signal (E) to obtain an output, signal (F);
   wherein the negative noise filter circuit (130) comprises a first RC filter (132) coupled with a first comparator (134) in series, with the first RC filter (132) receiving the first signal (C) and the first comparator (134) outputting the second signal (D); and
   the positive noise filter circuit (140) comprises a second RC filter (142) coupled with a second comparator (144) in series, with the second RC filter (142) receiving the first signal (C) and the second comparator (144) outputting the third signal (E);
   wherein the first RC filter (132) comprises a first transistor and the second RC filter (142) comprises a second transistor, the first transistor and the second transistor are configured to receive the first signal (C) such that the corresponding capacitors (C1, C2) in the first RC filter (132) and the second RC filter (142) are short-circuited when the first signal (C) is in high level.

2. The apparatus according to Claim 1, wherein the first RC filter (132) comprises a first resistor (R1) and a first capacitor (C1), and wherein the first RC filter (132) is constructed in the form of a low pass filter.

3. The apparatus according to Claim 1, wherein the second RC filter (142) comprises a second resistor (R2) and a second capacitor (C2), and wherein the second RC filter (142) is constructed in the form of a high pass filter.

4. The apparatus according to Claim 1, wherein the first comparator (134) comprises a first operational amplifier, and the second comparator (144) comprises a second operational amplifier.

5. The apparatus according to any one of Claims 1 to 4, wherein a cathode of a first diode (136) is connected to the output of the first comparator (134) to receive the second signal (D).

6. The apparatus according to any one of Claims 1 to 5, wherein the anode of a second diode (146) is connected to the output of the second comparator (144) to receive the third signal (E).

7. The apparatus according to any one of Claims 1 to 6, wherein input voltage of the first RC filter (132) is higher than the reference voltage of the first comparator (134) and input voltage of the second RC filter (142) is higher than the reference voltage of the second comparator (144).

8. The apparatus according to any one of the preceding Claims, wherein the combiner circuit (150) comprises a third operational amplifier (152), a third resistor (R4) and a third capacitor (C3), the third operational amplifier (152) comprises a non-inverting input, an inverting input and an output, wherein the third resistor (R4) and the third capacitor (C3) are electrically coupled in parallel with one end connected to the non-inverting input of the third operational amplifier (152) and the other end connected to the output of the third operational amplifier (152).

9. A method for filtering noises in an input signal (B), comprising:

   filtering hysteresis noises in the input signal (B) with a hysteresis filter circuit (110) to obtain a first signal (C);
   filtering negative impulse noises in the first signal (C) with a negative noise filter circuit (130) to obtain a second signal (D);
filtering positive impulse noises in the first signal (C) with a positive noise filter circuit (140) filter to obtain a third signal (E), wherein the a positive noise filter circuit (140) is coupled with the negative noise filter circuit (130) in parallel; and
combining the second signal (D) with the third signal (E) through a combiner circuit (150) to obtain an output signal (F);
wherein the negative noise filter circuit (130) comprises a first RC filter (132) coupled with a first comparator (134) in series, and the positive noise filter circuit (140) comprises a second RC filter (142) coupled with a second comparator (144) in series;
wherein the first RC filter (132) comprises a first transistor and the second RC filter (142) comprises a second transistor, the first transistor and the second transistor are configured to receive the first signal (C) such that a corresponding capacitor (C1) in the first RC filter (132) and a corresponding capacitor (C2) in the second RC filter (142) are short-circuited when the first signal (C) is in high level.

10. The method according to Claim 9, wherein the first RC filter (132) comprises a first resistor (R1) and a first capacitor (C1) constructed in the form of a low pass filter, and the second RC filter (142) comprises a second resistor (R2) and a second capacitor (C2) constructed in the form of a high pass filter.

11. The method according to any of Claims 9-10, wherein the combiner circuit (150) comprises a third operational amplifier (152), and a third resistor (R4) and a third capacitor (C3), the third operational amplifier (152) comprises a non-inverting input, an inverting input and a output, wherein the third resistor (R4) and the third capacitor (C3) are electrically coupled in parallel with one end connected to the non-inverting input of the third operational amplifier (152) and the other end connected to the output of the third operational amplifier (152).

**Patentansprüche**

1. Vorrichtung (100) zum Filtern von Geräuschen in einem Eingangssignal (B), umfassend:

   eine Hysteresefilterschaltung (110), die zum Filtern von Hysteresegeräuschen im Eingangssignal (B) ausgelegt ist, um ein erstes Signal (C) zu erhalten;
   eine Impulsgeräuschfilterschaltung (120), die eine Negativgeräuschfilterschaltung (130) umfasst, die dazu ausgelegt ist, Negativimpulsgeräusche im ersten Signal (C) zu filtern, um ein zweites Signal (D) zu erhalten; und

eine Positivgeräuschfilterschaltung (140), die mit der Negativgeräuschfilterschaltung (130) parallel geschaltet und dazu ausgelegt ist, Positivimpulsgeräusche im ersten Signal (C) zu filtern, um ein drittes Signal (E) zu erhalten; und

eine Kombinierschaltung (150), die dazu ausgelegt ist, das zweite Signal (D) und das dritte Signal (E) zu kombinieren, um ein Ausgangssignal (F) zu erhalten;

wobei die Negativgeräuschfilterschaltung (130) einen ersten RC-Filter (132) umfasst, der mit einem ersten Komparator (134) in Reihe geschaltet ist, wobei der erste RC-Filter (132) das erste Signal (C) empfängt und der erste Komparator (134) das zweite Signal (D) ausgibt; und

die Positivgeräuschfilterschaltung (140) einen zweiten RC-Filter (142) umfasst, der mit einem zweiten Komparator (144) in Reihe geschaltet ist, wobei der zweite RC-Filter (142) das erste Signal (C) empfängt und der zweite Komparator (144) das dritte Signal (E) ausgibt;

wobei der erste RC-Filter (132) einen ersten Transistor umfasst und der zweite RC-Filter (142) einen zweiten Transistor umfasst, wobei der erste Transistor und der zweite Transistor dazu ausgelegt sind, das erste Signal (C) zu empfangen, sodass die entsprechenden Kondensatoren (C1, C2) in dem ersten RC-Filter (132) und dem zweiten RC-Filter (142) kurzgeschlossen sind, wenn das erste Signal (C) auf hohem Pegel liegt.

2. Vorrichtung gemäß Anspruch 1, wobei der erste RC-Filter (132) einen ersten Widerstand (R1) und einen ersten Kondensator (C1) umfasst und wobei der erste RC-Filter (132) in Form eines Tiefpassfilters aufgebaut ist.

3. Vorrichtung gemäß Anspruch 1, wobei der zweite RC-Filter (142) einen zweiten Widerstand (R2) und einen zweiten Kondensator (C2) umfasst und wobei der zweite RC-Filter (142) in Form eines Hochpassfilters aufgebaut ist.

4. Vorrichtung gemäß Anspruch 1, wobei der erste Komparator (134) einen ersten Operationsverstärker umfasst und der zweite Komparator (144) einen zweiten Operationsverstärker umfasst.

5. Vorrichtung gemäß einem der Ansprüche 1 bis 4, wobei eine Kathode einer ersten Diode (136) mit dem Ausgang des ersten Komparators (134) verbunden ist, um das zweite Signal (D) zu empfangen.

6. Vorrichtung gemäß einem der Ansprüche 1 bis 5, wobei die Anode einer zweiten Diode (146) mit dem Ausgang des zweiten Komparators (144) verbunden ist, um das dritte Signal (E) zu empfangen.

7. Vorrichtung gemäß einem der Ansprüche 1 bis 6, wobei die Eingangsspannung des ersten RC-Filters (132) höher als die Referenzspannung des ersten Komparators (134) ist und die Eingangsspannung des zweiten RC-Filters (142) höher als die Referenzspannung des zweiten Komparators (144) ist.

8. Vorrichtung gemäß einem der vorhergehenden Ansprüche, wobei die Kombinierschaltung (150) einen dritten Operationsverstärker (152), einen dritten Widerstand (R4) und einen dritten Kondensator (C3) umfasst, der dritte Operationsverstärker (152) einen nicht-invertierenden Eingang, einen invertierenden Eingang und einen Ausgang umfasst, wobei der dritte Widerstand (R4) und der dritte Kondensator (C3) elektrisch parallel geschaltet sind, wobei ein Ende mit dem nicht-invertierenden Eingang des dritten Operationsverstärkers (152) und das andere Ende mit dem Ausgang des dritten Operationsverstärkers (152) verbunden ist.

9. Verfahren zum Filtern von Geräuschen in einem Eingangssignal (B), umfassend:

Filtern von Hysteresegeräuschen im Eingangssignal (B) mit einer Hysteresefilterschaltung (110), um ein erstes Signal (C) zu erhalten;
Filtern von Negativimpulsgeräuschen im ersten Signal (C) mit einer Negativgeräuschfilterschaltung (130), um ein zweites Signal (D) zu erhalten;
Filtern von Positivimpulsgeräuschen im ersten Signal (C) mit dem Filter einer Positivgeräuschfilterschaltung (140), um ein drittes Signal (E) zu erhalten, wobei die Positivgeräuschfilterschaltung (140) mit der Negativgeräuschfilterschaltung (130) parallel geschaltet ist; und
Kombinieren des zweiten Signals (D) mit dem dritten Signal (E) über eine Kombinierschaltung (150), um ein Ausgangssignal (F) zu erhalten;
wobei die Negativgeräuschfilterschaltung (130) einen ersten RC-Filter (132) umfasst, der mit einem ersten Komparator (134) in Reihe geschaltet ist, und die Positivgeräuschfilterschaltung (140) einen zweiten RC-Filter (142) umfasst, der mit einem zweiten Komparator (144) in Reihe geschaltet ist;
wobei der erste RC-Filter (132) einen ersten Transistor und der zweite RC-Filter (142) einen zweiten Transistor umfasst, wobei der erste Transistor und der zweite Transistor dazu ausgelegt sind, das erste Signal (C) zu empfangen, sodass ein entsprechender Kondensator (C1) im ersten RC-Filter (132) und ein entsprechender Kondensator (C2) im zweiten RC-Filter (142) kurzgeschlossen sind, wenn das erste Signal (C) auf hohem Pegel liegt.

10. Verfahren gemäß Anspruch 9, wobei der erste RC-Filter (132) einen ersten Widerstand (R1) und einen ersten Kondensator (C1) umfasst, die in Form eines Tiefpassfilters aufgebaut sind, und der zweite RC-Filter (142) einen zweiten Widerstand (R2) und einen zweiten Kondensator (C2) umfasst, die in Form eines Hochpassfilters aufgebaut sind.

11. Verfahren gemäß einem der Ansprüche 9-10, wobei die Kombinierschaltung (150) einen dritten Operationsverstärker (152) und einen dritten Widerstand (R4) und einen dritten Kondensator (C3) umfasst, der dritte Operationsverstärker (152) einen nicht-invertierenden Eingang, einen invertierenden Eingang und einen Ausgang umfasst, wobei der dritte Widerstand (R4) und der dritte Kondensator (C3) elektrisch parallel geschaltet sind, wobei ein Ende mit dem nicht-invertierenden Eingang des dritten Operationsverstärkers (152) und das andere Ende mit dem Ausgang des dritten Operationsverstärkers (152) verbunden ist.

## Revendications

1. Appareil (100) pour filtrer des bruits dans un signal d'entrée (B), comprenant
   un circuit de filtre par hystérésis (110) configuré pour filtrer par hystérésis des bruits dans le signal d'entrée (B) pour obtenir un premier signal (C),
   un circuit de filtre de bruits d'impulsion (120) comprenant un circuit de filtre de bruits négatifs (130) configuré pour filtrer des bruits d'impulsion négatifs dans le premier signal (C) pour obtenir un deuxième signal (D) ; et
   un circuit de filtre de bruits positifs (140) couplé au circuit de filtre de bruits négatifs (130) en parallèle, et configuré pour filtrer des bruits d'impulsion positifs dans le premier signal (C) pour obtenir un troisième signal (E), et
   un circuit combinateur (150) configuré pour combiner le deuxième signal (D) et le troisième signal (E) pour obtenir un signal de sortie (F) ;
   dans lequel le circuit de filtre de bruits négatifs (130) comprend un premier filtre RC (132) couplé à un premier comparateur (134) en série, le premier filtre RC (132) recevant le premier signal (C) et le premier comparateur (134) produisant en sortie le deuxième signal (D), et
   le circuit de filtre de bruits positifs (140) comprend un second filtre RC (142) couplé à un second comparateur (144) en série, le second filtre RC (142) recevant le premier signal (C) et le second comparateur (144) produisant en sortie le troisième signal (E) ;

   dans lequel le premier filtre RC (132) comprend un premier transistor et le second filtre RC (142) comprend un second transistor, le premier transistor et le second transistor sont configurés pour recevoir le premier signal (C) de telle sorte que les condensateurs correspondants (C1, C2) dans le premier filtre RC (132) et le second filtre RC (142) soient court-circuités lorsque le premier signal (C) est en haut niveau.

2. Appareil selon la revendication 1, dans lequel le premier filtre RC (132) comprend une première résistance (R1) et un premier condensateur (C1), et dans lequel le premier filtre RC (132) est construit sous la forme d'un filtre passe-bas.

3. Appareil selon la revendication 1, dans lequel le second filtre RC (142) comprend une deuxième résistance (R2) et un deuxième condensateur (C2), et dans lequel le second filtre RC (142) est construit sous la forme d'un filtre passe-haut.

4. Appareil selon la revendication 1, dans lequel le premier comparateur (134) comprend un premier amplificateur opérationnel, et le second comparateur (144) comprend un deuxième amplificateur opérationnel.

5. Appareil selon l'une quelconque des revendications 1 à 4, dans lequel une cathode d'une première diode (136) est connectée à la sortie du premier comparateur (134) pour recevoir le deuxième signal (D).

6. Appareil selon l'une quelconque des revendications 1 à 5, dans lequel l'anode d'une seconde diode (146) est connectée à la sortie du second comparateur (144) pour recevoir le troisième signal (E).

7. Appareil selon l'une quelconque des revendications 1 à 6, dans lequel la tension d'entrée du premier filtre RC (132) est plus élevée que la tension de référence du premier comparateur (134) et la tension d'entrée du second filtre RC (142) est plus élevée que la tension de référence du second comparateur (144).

8. Appareil selon l'une quelconque des revendications précédentes, dans lequel le circuit combinateur (150) comprend un troisième amplificateur opérationnel (152), une troisième résistance (R4) et un troisième condensateur (C3), le troisième amplificateur opérationnel (152) comprend une entrée non inverseuse, une entrée inverseuse et une sortie, dans lequel la troisième résistance (R4) et le troisième condensateur (C3) sont électriquement couplés en parallèle à une extrémité connectée à l'entrée non inverseuse du troisième amplificateur opérationnel (152) et l'autre extrémité connectée à la sortie du troisième amplificateur opérationnel (152).

**9.** Procédé pour filtrer des bruits dans un signal d'entrée (B), comprenant :

le filtrage par hystérésis de bruits dans le signal d'entrée (B) avec un circuit de filtre par hystérésis (110) pour obtenir un premier signal (C), le filtrage de bruits d'impulsion négatifs dans le premier signal (C) avec un circuit de filtre de bruits négatifs (130) pour obtenir un deuxième signal (D), le filtrage de bruits d'impulsion positifs dans le premier signal (C) avec un circuit de filtre de bruits positifs (140) pour obtenir un troisième signal (E), dans lequel le circuit de filtre de bruits positifs (140) est couplé au circuit de filtre de bruits négatifs (130) en parallèle ; et la combinaison du deuxième signal (D) avec le troisième signal (E) par l'intermédiaire d'un circuit combinateur (150) pour obtenir un signal de sortie (F) ; dans lequel le circuit de filtre de bruits négatifs (130) comprend un premier filtre RC (132) couplé à un premier comparateur (134) en série, et le circuit de filtre de bruits positifs (140) comprend un second filtre RC (142) couplé à un second comparateur (144) en série ; dans lequel le premier filtre RC (132) comprend un premier transistor et le second filtre RC (142) comprend un second transistor, le premier transistor et le second transistor sont configurés pour recevoir le premier signal (C) de telle sorte qu'un condensateur correspondant (C1) dans le premier filtre RC (132) et un condensateur correspondant (C2) dans le second filtre RC (142) soient court-circuités lorsque le premier signal (C) est en haut niveau.

**10.** Procédé selon la revendication 9, dans lequel le premier filtre RC (132) comprend une première résistance (R1) et un premier condensateur (C1) construits sous la forme d'un filtre passe-bas, et le second filtre RC (142) comprend une deuxième résistance (R2) et un deuxième condensateur (C2) construits sous la forme d'un filtre passe-haut.

**11.** Procédé selon l'une quelconque des revendications 9 et 10, dans lequel le circuit combinateur (150) comprend un troisième amplificateur opérationnel (152), et une troisième résistance (R4) et un troisième condensateur (C3), le troisième amplificateur opérationnel (152) comprend une entrée non inverseuse, une entrée inverseuse et une sortie, dans lequel la troisième résistance (R4) et le troisième condensateur (C3) sont électriquement couplés en parallèle à une extrémité connectée à l'entrée non inverseuse du troisième amplificateur opérationnel (152) et l'autre extrémité connectée à la sortie du troisième amplificateur opérationnel (152).

100

120

Input — Hysteresis filter circuit — Impulse noise filter circuit — Combiner circuit — Output

110

**Fig. 1**

100

130    132    134

Input — Hysteresis filter circuit — First RC filter — First comparator — Combiner circuit — Output

110

Second RC filter — Second comparator

140    142    144    150

**Fig. 2**

**Fig. 3**

**Fig. 4**

**EP 3 138 218 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- GB 2028064 A